# EUROPEAN PATENT SPECIFICATION

(11) **EP 0 325 532 B1**
(45) Date of publication and mention of the grant of the patent: **12.04.1995**
(21) Application number: 89400148.6
(22) Date of filing: 18.01.1989
(51) Int. Cl.: H01L 31/10

(54) **A semiconductor photo-diode**
Halbleiterphotodiode
Photodiode à semiconducteur

(30) Priority: 18.01.1988 JP 7702/88
(43) Date of publication of application: 26.07.1989
(73) Proprietor: FUJITSU LIMITED, Kawasaki-shi, Kanagawa 211 (JP)
(72) Inventor: Miura, Shuichi, Kawasaki-shi Kanagawa 213 (JP); Mikawa, Takashi, Setagaya-ku Tokyo 158 (JP); Kuwatsuka, Haruhiko, Yokahama-shi Kanagawa 246 (JP); Yasuoka, Nami, Hachioji-shi Tokyo 192 (JP)
(74) Representative: Joly, Jean-Jacques

(56) References cited:
- EP-A- 0 076 495
- EP-A- 0 163 295
- EP-A- 0 242 298
- US-A- 4 110 778

## Description

### Field of the Invention

This invention relates to a semiconductor avalanche photo-diode (referred to hereinafter as APD). More particularly, it relates to an APD capable of low noise as well as high speed operation.

### Description of the Related Art

Long-distance, high-capacity optical transmission using a wave length of 1.0 to 1.7 »m, in which the optical transmission loss of a silica optical fiber becomes minimum, has been increasing in practical use. As an optical detector for this application, many types of APD devices have been developed. A typical one was the object of U.S. Patent application No. 037,000. In this prior application, as schematically illustrated in FIG. 1, where the numeral 1 denotes an n⁺-type GaSb substrate; the numeral 2 denotes an n-type GaSb light absorbing layer; the numeral 3 denotes an n-type AlₓGa₁₋ₓSb avalanche multiplication layer, where x=0.065; the numeral 4A denotes an n⁻-type AlₓGa₁₋ₓSb window layer 3; and the numeral 5 denotes a p⁺-type region doped in the window layer for forming a pn-junction, while some thickness of the window layer 4A is left between the pn junction 5′ and the avalanche multiplication layer 3; and a light to be detected is injected through the p⁺-type region 5 into the light absorbing layer 2. The above-described material of the avalanche multiplication layer 3 generates a high ionization rate of positive holes to that of electrons by a resonant impact ionization phenomena, resulting in an achievement of low noise and high speed operation of the APD. The resonant impact ionization is disclosed by O. Hilderbrand et al. in IEEE Journal of Quantum Electronics, vol. QE-17, No.2, p284-288, Feb. 1981.

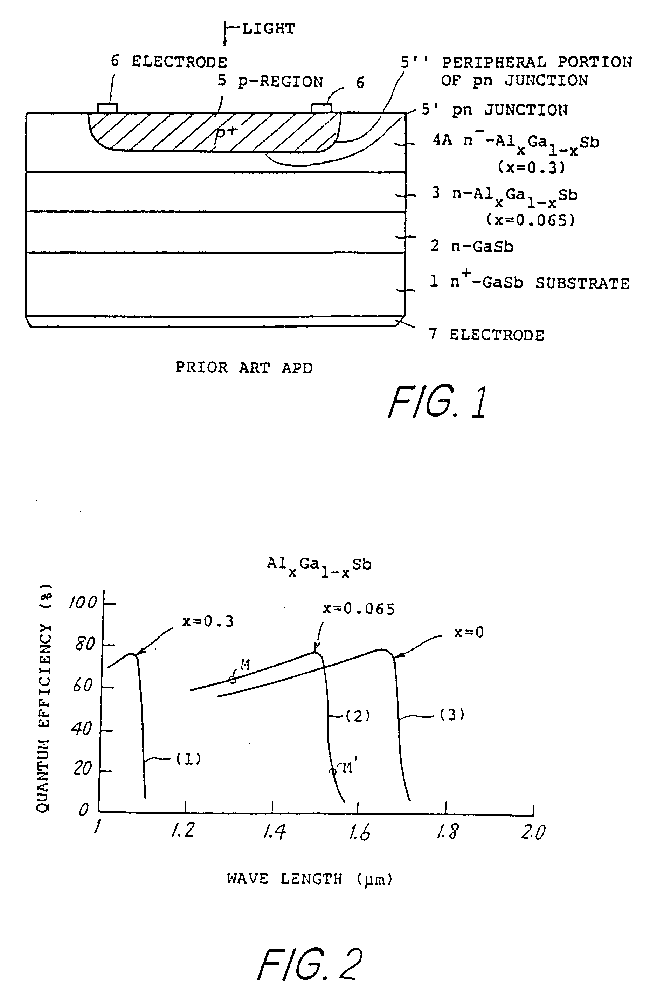

Problems of the cited first prior art APD are hereinafter described. In FIG. 2, characteristics of quantum efficiency, which is an average number of electrons or positive holes photoelectrically emitted in a photoelectric material per incidental photon (i.e. a unit intensity of light) versus the incidental wave length, is presented. The incidental light having 1.3 »m wavelength produces both carriers, i.e. electrons and positive holes, in the avalanche multiplication layer 3 having x of 0.065, as indicated by a mark "M", even though the light should pass therethrough without producing carriers therein. The most important feature of employing the resonant impact ionization that reduces the noise generation is enjoyed when only the positive carriers are injected from the light absorbing layer 2 into the avalanche multiplication layer 3. Accordingly, the undesirable generation of both carriers i.e. electrons and positive holes, in the multiplication layer 3 deteriorates the pure generation of the resonant impact ionization, accordingly, deteriorates the low noise characteristics of the APD. The same problem still exists for a 1.55 »m wavelength incidental light as indicated by a mark "M′", through the amount of the produced carriers is much less.

Another prior art APD disclosed by the same assignee in Japanese unexamined patent publication Sho 60-105281 is schematically illustrated in FIG. 3, where the numeral 3-11 denotes a p⁺-type GaSb substrate; the numeral 3-12 denotes a p-type Ga_{0.935}Al_{0.065}Sb avalanche multiplication layer which generates a resonant impact ionization phenomena; the numeral 3-13 denotes a p-type Ga_{0.9}Al_{0.1}Sb light absorbing layer; the numeral 3-14 denotes a p-type Ga_{0.6}Al_{0.4}Sb window layer; the numeral 3-15 denotes an n⁺-type region doped in the window layer for forming a pn junction; the numeral 3-18 denotes an anti-reflection layer; and the numerals 3-19 and 3-20 denote electrodes for applying a bias voltage to the APD. The light to be detected is injected through the n⁺ region 3-15 into the light absorbing layer 3-13, and accordingly, does not have to pass through the avalanche multiplication layer 3-12. Therefore, the problem of the first prior art APD is avoided. However, other problems are thereby created. Because the pn junction is located far from the avalanche multiplication layer 3-12, fluctuations of the impurity density or the thickness, etc., of the layers therebetween in the fabrication process seriously affect the APD characteristics. Furthermore, there are difficulties in designing and fabricating the n⁺ region; for instance, with currently available diffusion source materials, such as sulfur or selenium, for forming the n⁺ region, it is difficult to achieve an adequate diffusion depth.

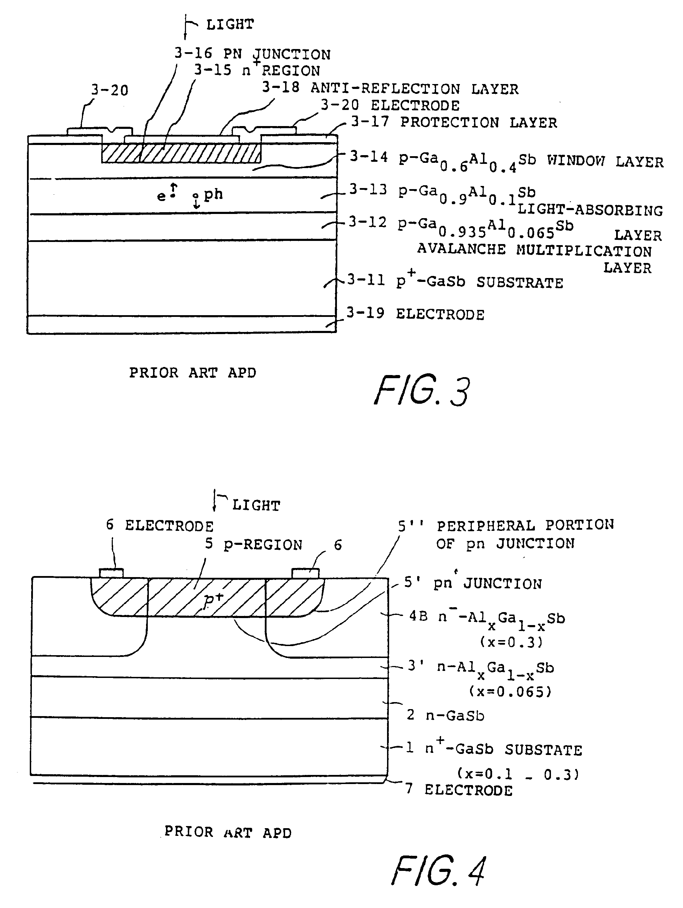

A third prior art APD is schematically illustrated in FIG. 4, where the same or like numerals denote the same or corresponding devices of FIG. 1. A substrate 1, and a light absorbing layer 2 are the same as those of FIG. 1. An avalanche multiplication layer 3′ is formed of the same material in the same way as in FIG. 1, but in a mesa shape. A peripheral portion of the mesa is filled with the same material as that of the window layer 4A, so as to form a guard-ring 4B. Onto the surface of the mesa-shaped window layer 3′ and an adjacent part of the guard-ring 4B, zinc is diffused approximately 1 »m deep to form a p⁺-type region 5. The p⁺-type region 5 forms a pn junction 5′ in the avalanche multiplication layer 3′ as well as in the guard-ring 4B. A light to be detected is injected through the p⁺-type region 5 into the light absorbing layer 2. The problem of the third prior art APD is the same as that of the first prior art APD shown in FIG. 1.

Another type of avalanche photodiode disclosed in US-A-4 110 778 has an inverted structure so that light enters through the substrate side of the device. The light energy is absorbed as it enters the active region where a high field p-n junction is created.

In another device disclosed in EP-A-0 242 298, the light enters through a large bandgap window layer located at a side opposite the substrate. The multiplication takes place in a layer between the window layer and an absorbing layer having a bandgap smaller than that of the window layer. This configuration is intended to reduce the field intensity at the light absorbing layer to reduce dark current.

### SUMMARY OF THE INVENTION

It is a general object of the invention to provide an APD having low noise and high speed characteristics.

It is another object of the invention to provide an APD having an improved quantum efficiency.

It is still another object of the invention to provide a wide margin in designing an APD structure.

The basic features of the photodiodes according to the present invention are defined in claims 1 and 3.

The avalanche multiplication layer of the present photodiode has an aluminum content chosen so as to produce a high ionization rate ratio, by a resonant impact ionization phenomena, generated with only the positive carriers by an electric field induced from the pn junction being located close (i.e. directly or only via the surface layer) to the avalanche multiplication layer; therefore, resulting in a low noise and high speed operation of the APD.

The above-mentioned features and advantages of the present invention, together with other objects and advantages which will become apparent, will be more fully described hereinafter, reference being had to the accompanying drawings forming a part hereof, wherein like numerals refer to like parts throughout.

### BRIEF DESCRIPTION OF THE DRAWINGS

FIG. 1 schematically illustrates a prior art APD.

FIG. 2 shows quantum efficiency versus incidental wave length for various aluminum content ratio of AlₓGaₗ₋ₓSb.

FIG. 3 schematically illustrates a second prior art APD.

FIG. 4 schematically illustrates a third prior art APD.

FIG. 5 schematically illustrates a cross-sectional side view of a preferred embodiment of the present invention.

FIG. 6 is a graph of the effect of aluminum content on ionization rate ratio.

FIG. 7 schematically illustrates a cross-sectional side view of a second preferred embodiment of the present invention.

FIG. 8 shows a comparison of noise figures achieved by an APD of the present invention with a prior art APD.

### DESCRIPTION OF THE PREFERRED EMBODIMENTS

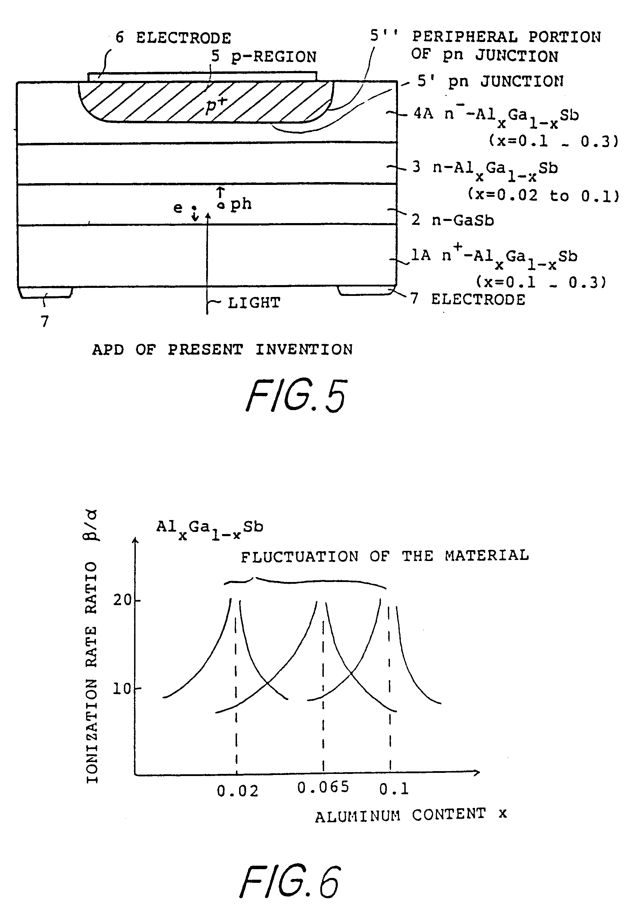

Referring to FIG. 5, a preferred embodiment of the present invention is hereinafter described in detail. A semiconductor substrate 1A having a thickness of approximately 350 »m and comprised of n⁺-type AlₓGaₗ₋ₓSb (aluminum gallium antimony) where x is approximately from 0.1 to 0.3, doped with an impurity such as tellurium having a concentration of typically 10¹⁹cm⁻³, is formed by liquid phase epitaxy (LPE), for which a method disclosed in U.S. Patent No. 4,620,897, "Method for Growing Multi-Component Compound Semiconductor Crystals" dated November 4, 1986 by K. Nakajima, is preferably used. With this method, a source can be automatically supplemented into the melt to form a thick substrate. A light absorbing layer 2 is formed of an n-type GaSb (gallium antimony) doped typically with tellurium having a concentration of an impurity such as LPE, typically of approximately 5 x 10¹⁵cm⁻³, as thick as approximately from 2 to 3 »m, on the semiconductor substrate 1A by a widely known method. An avalanche multiplication layer 3 is formed of an n-type AlₓGaₗ₋ₓSb, where x is approximately from 0.02 to 0.1, typically approximately 0.065, doped typically with tellurium having a concentration of an impurity such as LPE, typically 5 x 10¹⁵cm⁻³, as thick as approximately 1 »m on the light absorbing layer 2 by a widely known method. A surface layer 4A is formed of an n⁻-type AlₓGaₗ₋ₓSb, where x is from 0.1 to 0.3, doped typically with tellurium having a concentration of an impurity such as LPE of 5 x 10¹⁵cm⁻³ maximum, typically 2 x 10¹⁵cm⁻³, as thick as approximately from 2 to 3 »m on the avalanche multiplication layer 3 by a widely known method. At the central surface of the surface layer 4A, a p⁺-type region 5 having an impurity concentration, typically approximately 10¹⁹cm⁻³ is formed approximately 1 »m deep for forming a pn junction 5′ in the surface layer 4A, while an approximately 1 »m thickness of the surface layer 4A is left between the pn junction 5′ and the avalanche multiplication layer 3. The p⁺-type region 5 is formed by a widely known method, such as diffusion of zinc or ion implantation of beryllium. An electrode 6 is formed by depositing typically Au/Zn/Au (gold, zinc and gold) as thick as 360/60/360 Å (10Å=1nm) for each material on the p⁺-type region 5, and further depositing thereon typically Au/Ti (gold and titanium) as thick as 2700/300 Å for each material, by a widely known method, such as sputtering, for applying a negative side of a bias voltage to the APD. A ring shaped electrode 7 is formed by depositing typically Au/AuGe (gold and gold-germanium alloy) as thick as 2700/300 Å for each material, on a surface, opposite to the light absorbing layer 2, of the substrate 1A, for connecting a return of the bias voltage. Through an opening at the centre portion of the electrode 7, the incidental light is injected into a portion to receive the light on the substrate 1A.

As represented in FIG. 2 by curve (1) for the material having x of 0.3 used for the substrate, the quantum efficiency of the wave length now in consideration for a practical communication use, i.e. mainly 1.3 and 1.55 »m, is essentially zero, in other words, the incidental light passes through the substrate while producing essentially no carriers therein. The light having passed through the substrate 1A enters into the light absorbing layer 2, where sufficient carriers are produced for a wide range of wave lengths, i.e. for both 1.3 and 1.55 »m wave lengths, as represented by curve (2) having sufficient quantum efficiency in FIG. 2. The carriers produced in the light absorbing layer 2 are both the positive holes ph and electrons e as denoted in FIG. 5. The produced positive hole ph is accelerated by the electric field induced by the applied bias voltage into the avalanche multiplication layer 3.

For the avalanche multiplication layer, the aluminum content x is particularly chosen so that an ionization rate ratio β/α indicates an ionization rate of the positive holes produced therein and α indicates an ionization rate of the electrons produced therein) is remarkably increased. This is known as resonant impact ionization.

The general idea of the resonant impact ionization is further explained hereinafter. Resonant impact ionization is a phenomena in which the spin orbit splitting Δ of the valence band becomes equal (thus called resonant) to the band gap energy E_{g} between the conduction band and the valence band. A large value of the ionization rate ratio β/α is obtained even at a lower voltage than that of the conventional avalanche break down which does not employ the resonant impact ionization. As is well known, the greater the value of the ionization rate ratio the greater the reduction in the fluctuation noise produced in the APD, and the faster the operation of the APD.

The particular aluminum content ratio optimum for the maximum ionization rate ratio varies from 0.02 to 0.1, typically 0.065 as shown in FIG. 6.

Owing to a sufficient electric field intensity, such as approximately 4 x 10⁴ V/cm, in the avalanche multiplication layer 3 and induced by an applied voltage as low as, for example, 12.5 V on the pn junction 5′ located close the the avalanche multiplication layer (in other words, separated only by a 1 um thick layer of the surface layer 4A), and owing to the resonant impact ionization, the ionization rate ratio can be as high as 20 or more.

The band gap energy of the substrate 1A is more the 1 eV. Band gap energy of the light-absorbing layer is typically 0.72 eV. The band gap energy of the avalanche multiplication layer 3 is typically 0.8 to 0.83 eV. Because an absorption edge of the quantum efficiency curve is inversely proportional to the band gap energy of the material as shown in FIG. 2, the high band gap energy of the substrate 1A allows the light to pass therethrough while generating no carriers therein. The band gap energy of the avalanche multiplication layer 3 allows for the generation of the resonant impact ionization.

Because the surface layer 4A, formed of AlₓGaₗ₋ₓSb, where x is from 0.1 to 0.3, has a lower impurity concentration as well as a lower ionization rate than the avalanche multiplication layer 3, resulting in a relatively high avalanche breakdown voltage, for example, more than 50 V, and also in the reduction of the concentration of electric field at peripheral portion 5˝ of the pn junction, the surface layer 4A contributes to reduce a tunnel current flowing therethrough, i.e. a dark current of the APD, even though a guard-ring, which has been widely employed in APD's in order to reduce the peripheral electric field concentration, is not provided in the APD of the embodiment shown in FIG. 4.

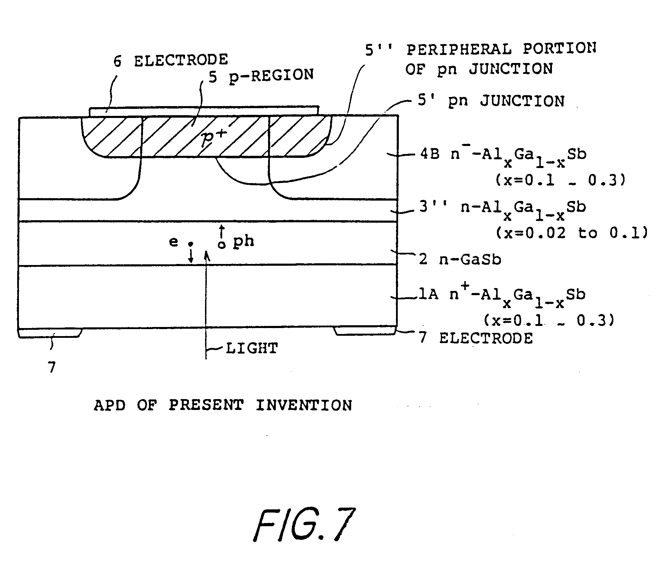

A second preferred embodiment of the present invention is hereinafter described, referring to FIG. 7, where the same or like numerals denote the same or corresponding devices. The substrate 1A and the light absorbing layer 2 are essentially the same and act respectively the same as those of the first preferred embodiment shown in FIG. 5. An avalanche multiplication layer 3˝ is formed of the same material as that of the first embodiment and as thick as, for example, 0.5 to 1.0 »m on the light absorbing layer 2 in essentially the same way as that of FIG. 5. Next, a peripheral portion of the deposited avalanche multiplication layer 3˝ is removed by a chemical etching so as to leave a mesa of the avalanche multiplication layer 3˝, while the centre portion is masked with a resist mask (not shown in the figure). Next, a guard-ring 4B is formed on the etched peripheral portion by filling with an n⁻-type AlₓGaₗ₋ₓSb having x of approximately 0.3 doped with, for example, tellurium of as low impurity concentration as 5 x 10¹⁵cm⁻³ maximum, typically 2 x 10¹⁵cm⁻³, typically by a widely used LPE technique, while the mask is left on the mesa. Next, after removing the mask from the top of the mesa, a positive dopant is doped into the surfaces of the avalanche multiplication layer 3˝ as well as the adjacent part of the guardring 4B approximately 1 »m deep typically by diffusing zinc or ion implanting beryllium, to a concentration of as much as typically 10¹⁹cm⁻³, as denoted with the hatched area 5. The p⁺ region 5 forms a pn junction 5′ in the avalanche multiplication layer 3˝ and the guard-ring 4B. However, because the peripheral portion 5˝ of the pn junction is located in the low impurity-doped guard-ring 4B having a low ionization rate, the undesirably low voltage avalanche breakdown caused by an electric field concentration at the peripheral portion can be prevented. Accordingly, the avalanche breakdown takes place only at the centre portion having no undesirable electric field concentration. The direct contact of the pn junction with the avalanche multiplication layer 3˝ is advantageous for inducing a high electric field intensity in the avalanche multiplication layer 3˝.

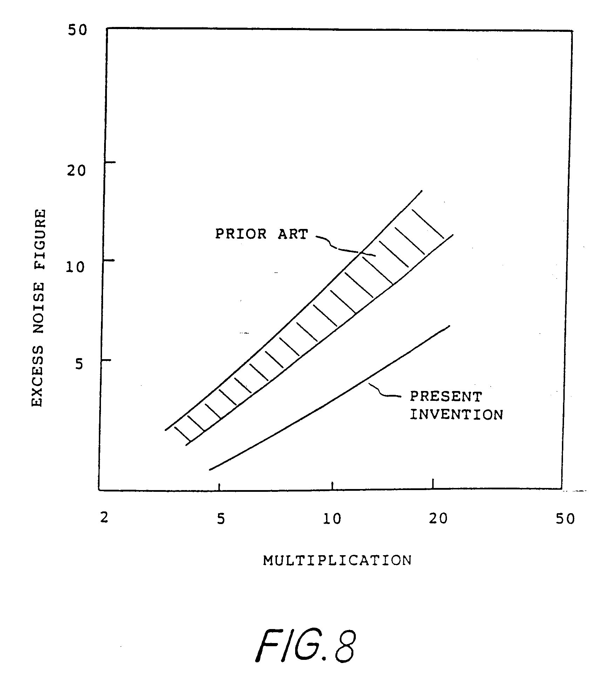

As shown in FIG. 8, at the multiplication factor of 10, an APD of the present invention achieved a noise as low as 3.8 compared with 6 to 9 of a prior art APD.

Mismatching of lattice constant of the crystals of the AlₓGaₗ₋ₓSb family with the GaSb light absorbing layer 2 increases slightly with the increased x value. Accordingly, the AlₓGaₗ₋ₓSb for the layers 1A, 3 and/or 4 may be replaced with AlₓGaₗ₋ₓSb_{y}As_{l-y} (aluminum gallium antimony arsenic) in order to achieve better matching of the lattice constant with the GaSb. Values of y are chosen: for example, 0.01 to 0.03 in the substrate; typically from 0.002 to 0.01 in the avalanche multiplication layer; and typically from 0.01 to 0.03 in surface layer 4A or the guard-ring 4B. The value of the content ratio y has essentially no effect on the above-described characteristics having various values of aluminum content x.

Though in the preferred embodiments of the present invention the electrode 7 is formed in a ring shape so that the light is injected through the opening into the substrate 1A, it is apparent that the structure of the electrode 7 is arbitrarily chosen as long as the bias voltage is properly applied to the APD device.

Owing to the fact that in the APD structure of the invention the light is injected from a side opposite the avalanche multiplication layer through a transparent substrate, a deterioration of quantum efficiency of the APD is prevented, resulting in an achievement of a low noise and fast operation of the APD. Furthermore, owing to the close location of the pn junction to the avalanche multiplication layer, the design of the electric field in the avalanche multiplication layer is facilitated as compared with the prior art APD structures.

## Claims

1. A semiconductor photodiode comprising:
a base layer substrate (1A) made of a semiconductor having a first band gap energy and having a first surface for receiving light and a second surface opposite to said first surface,
a light-absorbing layer (2) made of a semiconductor having a second band gap energy and formed on said second surface of the base layer, said second band being selected such that said light-absorbing layer receives said light and produces carriers corresponding to the intensity of the received light;
an avalanche multiplication layer (3) made of AlₓGa₁₋ₓSb or AlₓGa₁₋ₓSb_{y}As_{1-y} having a third band gap energy wherein the aluminum content ratio x is from 0.02 to 0.1 and the antimony content ratio y is 0 < y ≦ 1 and formed on said light-absorbing layer, the aluminum content ratio x in said avalanche multiplication layer being chosen so as to generate a maximum ionization rate ratio of positive holes to electrons, by a resonant impact ionization phenomenon;
a surface layer (4A) made of a semiconductor and formed on said multiplication layer (3; 3˝);
an impurity region (5) formed in said surface layer at a surface opposite from said multiplication layer, and having a conductivity type opposite to that of said surface layer;
a first electrode (7) formed on said first surface of the base layer for applying a bias voltage, said first electrode being shaped so as to allow an incidence of said light into a light receiving region of said substrate; and
a second electrode (6) formed on said impurity region for applying said bias voltage;
said first band gap energy being larger than said second and third band gap energies.

2. The semiconductor photodiode of claim 1, wherein:
said substrate (1A) is formed of an n-type AlₓGa₁₋ₓSb or AlₓGa₁₋ₓSb_{y}As_{1-y} semiconductor where the aluminum content ratio x is from 0.1 to 0.3 and the antimony content ratio y is 0 < y ≦ 1;
said light absorbing layer (2) is formed of an n-type GaSb semiconductor;
said surface layer (4A) is formed of an n-type AlₓGa₁₋ₓSb or AlₓGa₁₋ₓSb_{y}As_{1-y} semiconductor, where the aluminum content ratio x is 0 < x < 1 and is moreover larger than the aluminum content x in said multiplication layer (3) and the antimony content ratio y is 0 < y ≦ 1; and
said impurity region (5) is formed of a p-type semiconductor doped in said surface layer.

3. A semiconductor photodiode comprising :
a substrate (1A) formed of an n-type AlₓGa₁₋ₓSb or AlₓGa₁₋ₓSb_{y}As_{1-y} semiconductor having a first band gap energy, where the aluminum content ratio x is from 0.02 to 0.1 and the antimony content ratio y is 0 < y ≦ 1, a first surface of said substrate receiving light;
a light absorbing layer (2) formed of an n-type GaSb semiconductor;
and further comprising:
a light absorbing layer (2) formed of an n-type GaSb semiconductor on a second surface, opposite to said first surface of said substrate, said light absorbing layer receiving said light passing through said substrate so as to produce carriers corresponding to the intensity of said received light;
a multiplication layer (3˝) formed of an n-type AlₓGaₗ₋ₓSb or AlₓGaₗ₋ₓSb_{y}As_{l-y} semiconductor, where the aluminum content ratio x is from 0.02 to 0.1 and the antimony content ratio y is 0 < y ≦ 1, on said light absorbing layer, the aluminum content ratio x in said multiplication layer being chosen so as to generate a maximum ionization rate ratio of positive holes to electrons, by a resonant impact ionization phenomena, the thickness of a peripheral portion of said multiplication layer being thinner than a central portion of said multiplication layer;
a guard-ring region (4B) formed of an n-type AlₓGa₁₋ₓSb or AlₓGa₁₋ₓSb_{y}As_{1-y} semiconductor, where the aluminum content ratio x is 0 < x < 1 and is moreover larger than the aluminum content x in said multiplication layer (3˝) and the antimony content ratio y is 0 < y ≦ 1, on said thin peripheral portion of said multiplication layer (3˝), coplanarly with the surface of the central portion of said multiplication layer;
an impurity region (5) formed of a p-type semiconductor doped in said multiplication layer and in an adjacent portion of said guard-ring region, at surfaces opposite from said light absorbing layer;
a first electrode (7) formed on said first surface of said substrate, for applying a voltage, said first electrode being shaped so as to allow an incidence of said light into a light receiving region of said substrate;
a second electrode (6) formed on said impurity region, for applying a positive voltage with respect to said voltage applied to said first electrode.

4. The photodiode of claim 1 or 3, wherein the aluminum content ratio x is approximately 0.065 in said avalanche multiplication layer (3; 3˝).

5. The photodiode of claim 1, wherein, in said surface layer (4A), the aluminum content ratio x is from 0.1 to 0.3 and the impurity concentration is lower than approximately 5 x 10¹⁵cm⁻³.

6. The photodiode of claim 1 or 3, wherein said first electrode (7) is formed of a deposition of metallic material.

7. The photodiode of claim 1 or 3, wherein said second electrode (6) is formed of a deposition of metallic material.

## Patentansprüche

1. Halbleiterphotodiode enthaltend:
ein Basisschichtsubstrat (1A), das hergestellt ist aus einem Halbleiter mit einer ersten Bandabstandsenergie und mit einer ersten Oberfläche zur Aufnahme von Licht und einer der ersten Oberfläche entgegengesetzten zweiten Oberfläche;
eine lichtabsorbierende Schicht (2), die hergestellt ist aus einem Halbleiter mit einer zweiten Bandabstandsenergie und auf der zweiten Oberfläche der Basisschicht gebildet ist, wobei das zweite Band so gewählt ist, daß die lichtabsorbierende Schicht das Licht aufnimmt und Träger entsprechend der Intensität des aufgenommenen Lichts erzeugt;
eine Avalanchevervielfachungsschicht (3), die hergestellt ist aus AlₓGa₁₋ₓSb oder AlₓGa₁₋ₓSb_{y}As_{1-y} mit einer dritten Bandabstandsenergie, wobei das Aluminiumgehaltsverhältnis x von 0,02 bis 0,1 beträgt und das Antimongehaltsverhältnis y 0 < y ≦ 1 ist, und die auf der lichtabsorbierenden Schicht ausgebildet ist, wobei das Aluminiumgehaltsverhältnis x in der Avalanchevervielfachungsschicht so gewählt ist, daß durch ein Resonanzstoßionisationsphänomen ein maximales Ionisationsratenverhältnis von positiven Löchern zu Elektronen erzeugt wird;
eine Oberflächenschicht (4A), die aus einem Halbleiter hergestellt und auf der Vervielfachungsschicht (3; 3˝) gebildet ist;
einen Fremdstoffbereich (5), der in der Oberflächenschicht auf einer der Vervielfachungsschicht entgegengesetzten Oberfläche ausgebildet ist und einen dem der Oberflächenschicht entgegengesetzten Leitfähigkeitstyp hat;
eine erste Elektrode (7), die auf der ersten Oberfläche der Basisschicht ausgebildet ist, zum Anlegen einer Vorspannung, wobei die erste Elektrode so geformt ist, daß sie einen Einfall des Lichts in eine lichtaufnehmende Region des Substrats gestattet; und
eine zweite Elektrode (6), die auf dem Fremdstoffbereich ausgebildet ist, zum Anlegen der Vorspannung;
wobei die erste Bandabstandsenergie größer ist als die zweiten und dritten Bandabstandsenergien.

2. Halbleiterphotodiode nach Anspruch 1, bei welcher:
das Substrat (1A) aus einem n-Typ-AlₓGa₁₋ₓSb- oder AlₓGa₁₋ₓSb_{y}As_{1-y}-Halbleiter gebildet ist, wobei das Aluminiumgehaltsverhältnis x von 0,1 bis 0,3 beträgt und das Antimongehaltsverhältnis y 0 < y ≦ 1 ist;
die lichtabsorbierende Schicht (2) aus einem n-Typ-GaSb-Halbleiter gebildet ist;
die Oberflächenschicht (4A) aus einem n-Typ-AlₓGa₁₋ₓSb- oder AlₓGa₁₋ₓSb_{y}As_{1-y}-Halbleiter gebildet ist, wobei das Aluminiumgehaltsverhältnis x 0 < x < 1 ist und darüber hinaus größer als der Aluminiumgehalt x in der Vervielfachungsschicht (3) ist und das Antimongehaltsverhältnis y 0 < y ≦ 1 ist; und
der Fremdstoffbereich (5) aus einem in der Oberflächenschicht dotierten p-Typ-Halbleiter gebildet ist.

3. Halbleiterphotodiode enthaltend:
ein Substrat (1A), das aus einem n-Typ-AlₓGa₁₋ₓSb- oder AlₓGa₁₋ₓSb_{y}As_{1-y}-Halbleiter gebildet ist, mit einer ersten Bandabstandsenergie, wobei das Aluminiumgehaltsverhältnis x von 0,02 bis 0,1 beträgt und das Antimongehaltsverhältnis y 0 < y ≦ 1 ist, wobei eine erste Oberfläche des Substrats Licht aufnimmt;
eine lichtabsorbierende Schicht (2), die aus einem n-Typ-GaSb-Halbleiter gebildet ist;
und weiterhin enthaltend:
eine lichtabsorbierende Schicht (2), die aus einem n-Typ-GaSb-Halbleiter auf einer zweiten Oberfläche gebildet ist, die der ersten Oberfläche des Substrats entgegengesetzt ist, wobei die lichtabsorbierende Schicht das durch das Substrat hindurchtretende Licht aufnimmt, so daß es der Intensität des aufgenommenen Lichts entsprechende Träger erzeugt;
eine Vervielfachungsschicht (3˝), die aus einem n-Typ-AlₓGa₁₋ₓSb- oder AlₓGa₁₋ₓSb_{y}As_{1-y}-Halbleiter gebildet ist, wobei das Aluminiumgehaltsverhältnis x von 0,02 bis 0,1 beträgt und das Antimongehaltsverhältnis y 0 < y ≦ 1 ist, auf der lichtabsorbierenden Schicht, wobei das Aluminiumgehaltsverhältnis x in der Vervielfachungsschicht so gewählt ist, daß durch ein Resonanzstoßionisationsphänomen ein maximales Ionisationsratenverhältnis von positiven Löchern zu Elektronen erzeugt wird, wobei die Dicke eines Umfangsbereichs der Vervielfachungsschicht dünner ist als ein zentraler Bereich der Vervielfachungsschicht;
einen Schutzringbereich (4B), der aus einem n-Typ-AlₓGa₁₋ₓSb- oder AlₓGa₁₋ₓSb_{y}As_{1-y}-Halbleiter gebildet ist, wobei das Aluminiumgehaltsverhältnis x 0 < x < 1 ist und darüber hinaus größer ist als der Aluminiumgehalt x in der Vervielfachungsschicht (3˝) und das Antimongehaltsverhältnis y 0 < y ≦ 1 ist, auf dem dünnen peripheren Bereich der Vervielfachungsschicht (3˝), koplanar mit der Oberfläche des zentralen Bereichs der Vervielfachungsschicht;
einen Fremdstoffbereich (5), der aus einem in der Vervielfachungsschicht und in einem benachbarten Bereich des Schutzringbereichs dotierten p-Typ-Halbleiter an der lichtabsorbierenden Schicht entgegengesetzten Oberflächen gebildet ist;
eine erste Elektrode (7), die auf der ersten Oberfläche des Substrats gebildet ist, zum Anlegen einer Spannung, wobei die erste Elektrode so geformt ist, daß sie einen Einfall des Lichts in eine lichtaufnehmende Region des Substrats gestattet;
eine zweite Elektrode (6), die auf dem Fremdstoffbereich gebildet ist, zum Anlegen einer positiven Spannung in Bezug zu der der ersten Elektrode angelegten Spannung.

4. Photodiode nach Anspruch 1 oder 3, bei welcher das Aluminiumgehaltsverhältnis x in der Avalanchevervielfachungsschicht (3; 3˝) ungefähr 0,065 ist.

5. Photodiode nach Anspruch 1, bei welcher in der Oberflächenschicht (4A) das Aluminiumgehaltsverhältnis x von 0,1 bis 0,3 beträgt und die Fremdstoffkonzentration niedriger als ungefähr 5 x 10¹⁵cm⁻³ ist.

6. Photodiode nach Anspruch 1 oder 3, bei der die erste Photodiode (7) durch eine Niederschlagung von metallischem Material gebildet ist.

7. Photodiode nach Anspruch 1 oder 3, bei welcher die zweite Elektrode (6) durch eine Niederschlagung von metallischem Material gebildet ist.

## Revendications

1. Photodiode semiconductrice comprenant :
un substrat (1A) formant une couche de base, qui est fait d'un semiconducteur possédant une première énergie de bande interdite et comporte une première surface destinée à recevoir de la lumière et une deuxième surface opposée à ladite première surface ;
une couche (2) d'absorption de lumière, faite d'un semiconducteur qui possède une deuxième énergie de bande interdite et formée sur ladite deuxième surface de la couche de base, ladite deuxième énergie de bande interdite étant choisie de façon que ladite couche d'absorption de lumière reçoive ladite lumière et produise des porteurs en correspondance avec l'intensité de la lumière reçue ;
une couche (3) de multiplication par avalanche, faite de AlₓGa₁₋ₓSb ou AlₓGa₁₋ₓSb_{y}As_{1-y} possédant une troisième énergie de bande interdite, où la teneur en aluminium, x, est comprise entre 0,02 et 0,1 et la teneur en antimoine, y, est telle que 0 < y ≦1, et formée sur ladite couche d'absorption de lumière, la teneur x en aluminium de ladite couche de multiplication par avalanche étant choisie de façon à produire un rapport maximal du taux d'ionisation des trous positifs par rapport à celui des électrons, par un phénomène d'ionisation par impact résonnant ;
une couche de surface (4A) faite d'un semiconducteur et formée sur ladite couche de multiplication (3 ; 3˝) ;
une région d'impureté (5), formée dans ladite couche de surface en une surface qui est opposée à ladite couche de multiplication, et possédant une conductivité de type opposé à celui de ladite couche de surface ;
une première électrode (7) formée sur ladite première surface de la couche de base en vue de l'application d'une tension de polarisation, ladite première électrode ayant une forme propre à permettre l'arrivée de ladite lumière dans une région de réception de lumière dudit substrat ; et
une deuxième électrode (6) formée sur ladite région d'impureté en vue de l'application de ladite tension de polarisation ;
ladite première énergie de bande interdite étant plus grande que lesdites deuxième et troisième énergies de bande interdite.

2. Photodiode semiconductrice selon la revendication 1, où ledit substrat (1A) est formé d'un semiconducteur de AlₓGa₁₋ₓSb ou AlₓGa₁₋ₓSb_{y}As_{1-y} de type n, la teneur x en aluminium étant de 0,1 à 0,3 et la teneur y en antimoine étant telle que 0 < y ≦1 ;
ladite couche d'absorption de lumière (2) est formée d'un semiconducteur de GaSb de type n ;
ladite couche de surface (4A) est formée d'un semiconducteur de AlₓGa₁₋ₓSb ou AlₓGa₁₋ₓSb_{y}A_{1-y} de type n, où la teneur x en aluminium est telle que 0 < x <1 et étant par ailleurs supérieure à la teneur x en aluminium de ladite couche de multiplication (3), et la teneur y en antimoine est telle que 0 < y ≦1 ; et
ladite région d'impureté (5) est formée d'un semiconducteur de type p introduit par dopage dans ladite couche de surface.

3. Photodiode semiconductrice comprenant :
un substrat (1A), formé d'un semiconducteur de AlₓGa₁₋ₓSb ou AlₓGa₁₋ₓSb_{y}As_{1-y} de type n ayant une première énergie de bande interdite, où la teneur x en aluminium est comprise entre 0,02 et 0,1 et la teneur y en antimoine est telle que 0 < y ≦1, une première surface dudit substrat recevant la lumière ;
une couche d'absorption de lumière (2) formée d'un semiconducteur de GaSb de type n ;
et comprenant en outre :
une couche d'absorption de lumière (2) formée d'un semiconducteur de GaSb de type n sur une deuxième surface, qui est opposée à ladite première surface dudit substrat, ladite couche d'absorption de lumière recevant ladite lumière qui a traversé ledit substrat, de façon à produire des porteurs en correspondance avec l'intensité de ladite lumière reçue ;
une couche de multiplication (3˝) formée d'un semiconducteur de AlₓGa₁₋ₓSb ou AlₓGa₁₋ₓSb_{y}As_{1-y} de type n, où la teneur x en aluminium est comprise entre 0,02 et 0,1 et la teneur y en antimoine est telle que 0 < y ≦1, sur ladite couche d'absorption de lumière, la teneur x en aluminium de ladite couche de multiplication étant choisie de façon à produire un rapport maximal du taux d'ionisation des trous positifs à celui des électrons, par un phénomène d'ionisation par impact résonnant, l'épaisseur de la partie périphérique de ladite couche de multiplication étant plus mince que celle de la partie centrale de ladite couche de multiplication ;
une région d'anneau de garde (4B) formée d'un semiconducteur de AlₓGa₁₋ₓSb ou AlₓGa₁₋ₓSb_{y}As_{1-y} de type n, où la teneur x en aluminium est telle que 0 < x <1 et est par ailleurs supérieure à la teneur x en aluminium de ladite couche de multiplication (3˝), et la teneur y en antimoine est telle que 0 < y ≦1, sur ladite partie périphérique mince de ladite couche de multiplication (3˝), de façon coplanaire par rapport à la surface de la partie centrale de ladite couche de multiplication ;
une région d'impureté (5) formée d'un semiconducteur de type p introduit par dopage dans ladite couche de multiplication et dans une partie adjacente de ladite région anneau de garde, au niveau de surfaces opposées à ladite couche d'absorption de lumière ;
une première électrode (7) formée sur ladite première surface dudit substrat, en vue de l'application d'une tension, ladite première électrode ayant une forme propre à permettre l'arrivée de ladite lumière dans une région de réception de lumière dudit substrat ; et
une deuxième électrode (6) formée sur ladite région d'impureté, en vue de l'application d'une tension positive par rapport à ladite tension appliquée à ladite première électrode.

4. Photodiode selon la revendication 1 ou 3, où la teneur x en aluminium vaut approximativement 0,065 dans ladite couche de multiplication par avalanche (3; 3˝).

5. Photodiode selon la revendication 1, où, dans ladite couche de surface (4A), la teneur x en aluminium est comprise entre 0,1 et 0,3 et la concentration en impureté est inférieure à environ 5 x 10¹⁵cm⁻³.

6. Photodiode selon la revendication 1 ou 3, où ladite première électrode (7) est formée d'un dépôt de matériau métallique.

7. Photodiode selon la revendication 1 ou 3, où la deuxième électrode (6) est formée d'un dépôt de matériau métallique.
